# EUROPEAN PATENT APPLICATION

(11) **EP 3 376 160 A1**
(43) Date of publication of application: **19.09.2018**
(21) Application number: 16864660.2
(22) Date of filing: 19.10.2016
(51) Int. Cl.: G01C 11/28, G06T 17/00, G06K 9/62

(54) **METHOD AND SYSTEM FOR IDENTIFYING URBAN OBJECTS**

(30) Priority: 13.11.2015 RU 2015148840
(71) Applicant: Obschestvo s Ogranichennoi Otvetstvennostyu "Helgi LAB", Moscow 111123 (RU)
(72) Inventor: ILICHEV, Oleg Anatolievich, Moscow 127566 (RU); GEVORKOV, Sergey Yurievich, Moscow 105043 (RU); IVANCHENKO, Dmitry Leonidovich, Moscow 111397 (RU); PAVLYUCHENKOV, Alexey Vasilievich, d.Butovo Moskovskaya oblast 142718 (RU)
(74) Representative: Glawe, Delfs, Moll
(86) International application number: PCT/RU2016/050052
(87) International publication number: WO 2017/082774

(57) **Abstract**

The proposed solution relates to the field of information processing methods, in particular to a method and system for data processing. The technical result is to improve the accuracy of the urban objects determination in the construction of urban panorama models based on laser scanning data and photographic data. Declared is the computer-realizable way of urban objects recognition. It consists in the processing of primary data containing, at least, photographic data and laser scanning data, including information on urban sites, consisting of the following stages:
- cleaning and verification of the received primary data, containing city facilities;
- pre-processing of the cleared laser scanning data, in which:
- the construction of the normals to each of the cloud points is carried out;
- the construction of planes for sets of points clouds;
- the terrain and individual objects reliefs are built (for example, facades of buildings) with the help of photogrammetric algorithms based on photographs taken from different points in space;
- a consistent recognition of static urban objects from the set of cleaned laser scanning data and photographic data, in which city objects are determined;
- for each detected urban object, at least, geographical coordinates and linear dimensions are determined;
- creation of a polygonal model for each of the detected objects mentioned above.

## Description

### TECHNICAL SOLUTION

The proposed solution relates to the methods of processing information, in particular to a method and system of processing data from different sources (ground-based laser scanning and photo panoramas, aerial and space imagery, cartographic data, semantic information etc.), for subsequent recognition on certain types of urban objects, determining its coordinates and characteristics, the selection of the texture of objects and the subsequent export of the received information to various GIS and CAD-systems for further display of urban objects in the form of a three-dimensional urban models.

### BACKGROUND OF THE INVENTION

Various solutions are known in the field of object recognition in the world of today, based on analysis of photogrammetric and laser scanning data. There is also a technology known for recognition and constructing three-dimensional models of building facades on the basis of information obtained from point clouds of laser scanning followed by processing of the intermediate model and overlay on a three-dimensional frame of a photographic image (3D All The Way: Semantic Segmentation of Urban Scenes From Start to End in 3D // Andelo Martinovic et al.). This method is also used for semantic separation of three-dimensional urban models, to determine similar objects, based on a learning algorithm that allows to identify and mark similar objects, in particular, facades of buildings.

The known method is limited to the type of objects recognized, and it does not have sufficient accuracy.

### DISCLOSURE OF THE INVENTION

The objective of the claimed solution is to create a method and system of recognition of different types of urban objects represented on a different type of data, in particular photographic images and laser scanning data.

The technical result is to improve the accuracy of the recognition of urban objects in the construction of urban panorama models based on laser scanning data and photographic data.

One of the preferred implementation of the claimed invention is a computer-implemented method for recognizing of urban facilities, which includes processing of primary data, that contains at least photographic data and laser scanning data about urban objects. The method includes the following stages:
- cleaning and verification of the primary data which contains city facilities;
- pre-processing of the cleared data that includes:
   * the construction of the normals to each of the cloud points;
   * the construction of planes for sets of points clouds;
   * terrain and individual objects construction (for example, facades of buildings) with the help of photogrammetric algorithms based on processing data from photographs taken from different points in space;
- perform a consistent recognition of static urban objects from the set of cleaned laser scanning data and photographic data, in which city objects are defined;
- for each detected urban object at least geographical coordinates and linear dimensions are determined;
- a polygonal model for each of the detected objects is performed.

In a particular implementation the primary data contains additionally spatial geodata and/or semantic data and/or panoramic images.

In another particular implementation of the invention, photographic data are the data obtained from using mobile scanning and/or aerial and/or cosmic photography.

Other possible implementation of the invention based on spatial geodata represented by vector layers, which includes coordinates of the boundaries of urban objects.

In another particular implementation, the semantic data contains metadata of urban objects.

In another particular implementation of the invention, the original data are checked for quality of presentation of information at a very beginning.

In another particular implementation of the invention, in a stage of primary data processing, laser data processing is performed that includes deleting of points from point clouds that corresponds to the points formed due to interference in the laser scanning process, non-stationary objects, or points that are absent on the two or more laser scans of the same place.

In another particular implementation of the invention, testing of ground and air panoramas on the subject of image quality of recognized objects is performed.

In another particular implementation of the invention, in the stage of preliminary processing the localization of aerospace- and land photographs, as well as point clouds is carried out, for the detection of objects and determination of the order of their processing. In another particular implementation of the invention, in a stage of construction the normals of cloud points, for each cloud point the nearest neighboring points are determined.

In another particular implementation of the invention, for each points for which neighboring points are defined, the planes are constructed by the RANSAC method.

In another particular implementation, the normal to point is the normal vector of the plane that passes through the largest number of neighbors.

In another particular implementation of the invention, in the construction of planes, the points of the cloud are divided according to the planar grid, in each cell of which for each point and its corresponding normal neighboring points belonging to the plane described by this pair are sought.

In another particular implementation of the invention, the point with the maximum number of neighboring points along the plane are taken as the basis for the plane, with all the neighboring points are withdrawn from further processing.

In another particular implementation of the invention, all of the planes in one cell are checked for compatibility with planes of neighboring cells and if the test is successful, then the planes of neighboring points mentioned above are combined.

In another particular implementation of the invention, the distance L between the planes is verified and if the planes are located at a distance not exceeding L, then they are combined.

In another particular implementation of the invention, in a stage of sequential recognition of static urban objects the order of searching for object types is established by the search policy algorithm.

In another particular implementation, the recognition of urban objects are carried out on the basis of characteristic features established for each type of object.

In another particular implementation, the recognition of urban objects are carried out on the basis of a comparison of the identified objects from the processed data with reference objects from the database.

In another particular implementation of the invention, in a stage of the terrain construction additionally reliefs of individual objects are constructed.

In another preferred implementation of the invention, the system of recognition of urban objects, containing one or more processors and at least one memory storing machine-readable commands, which, when executed, at least, one processing unit performs processing of primary data containing, at least photographic data and laser scanning data, using the above-mentioned method for recognition of urban objects.

### BRIEF DESCRIPTION OF THE DRAWINGS

Fig. 1 is a flowchart of the steps of implementing the claimed invention.
Fig. 2-3 shows the principle of constructing normals on the basis of laser scanning data.
Fig. 4-5 shows an example of recognition of building.
Fig. 6 shows an example of recognition of poles in panoramic pictures.
Fig. 7 shows an example of recognition of billboards.
Fig. 8 shows the general scheme of the proposed system.

### DETAILED DESCRIPTION OF THE INVENTION

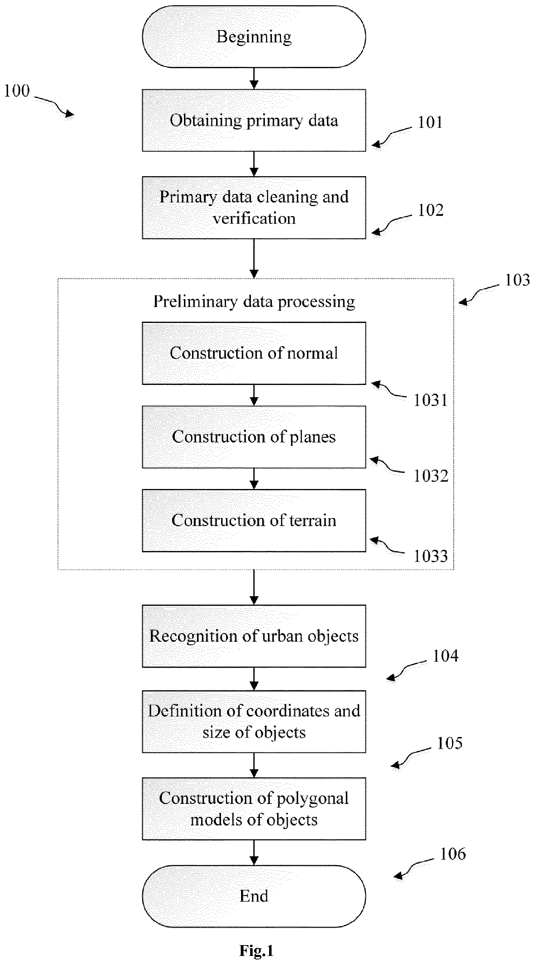

Fig. 1 shows a general scheme for performing the steps of the proposed method of recognition of urban objects (100). Urban objects are understood to be human made objects of the same type most common in the urban landscape: buildings and structures, fences, poles, traffic signs and traffic lights, public transport stops, advertising media, etc.

At step 101, primary data is received, representing at least photographic data and laser scanning data. Mobile scanning survey of urban areas is produced by a special software and hardware complex, installed on the top of the car which includes high-resolution panoramic cameras, laser scanners (range finders), devices for precision positioning of a car and control computer with a special software. The primary data are point clouds in *las* format (WGS84 coordinate system), panoramic photos jpg, the coordinates of the panoramas and the data from the GNSS base station. Also for terrestrial shooting can be used "stereopair", two panoramic cameras, fixed to a small distance from each other and removing simultaneously.

In addition to the initial data, for the analysis of territories from the air, combined georeferenced mosaic of aero- or space images in jpg / tiff formats with the coordinates of individual tiles can be used. It is also possible to use pictures in GeoTIFF format. Spatial data (geodata) for recognition are presented by vector layers in Shapefile format containing coordinates (system of coordinates WGS84 projection Web Mercator): boundaries of buildings, roads, and other objects. A variety of semantic related information can be also used for that purposes - the metadata by which the number of stores can appear, floor plans of buildings, etc.

In step 102, the received primary data is verified and cleaned, vector and raster data is loaded into the geodatabase (GDB) and validation of the data is preformed (correctness of formats, absence of inconsistent data, completeness of information, etc.). Processing point clouds, in particular removing "garbage" points caused by noise during shooting, removal of moving objects that are absent on different passes. The testing of ground and air panoramas for the processing abilities and quality of the information provided, for example, absence of clouds interfering with the restoration of the terrain and roofs, and localization of sites for the detection of objects and the definition of their order of processing, which determines the areas for processing that can be manually set or calculated automatically based on availability of the data.

Next, in step 103, preprocessing of processed and cleaned laser scanning data is performed. At step 103, five sub-steps are performed - 1031-1033.

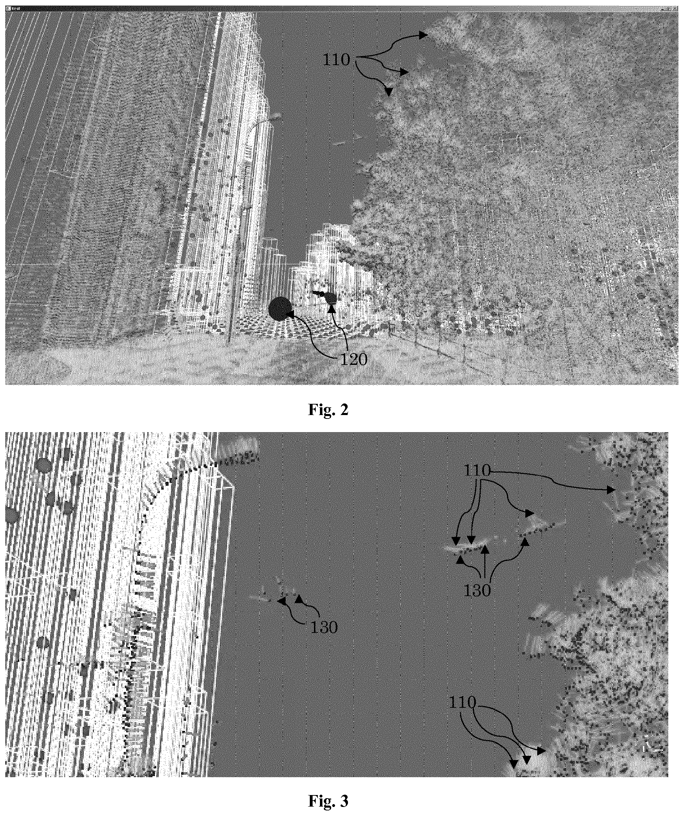

Fig. 2-3 shows an example of the work of the method in constructing normals to the points of the laser scanning cloud. On the sub-step #1031 of preparation of data definition and construction of normal 110 to each of the points of cloud 130 is performed (Figure 3), the union of points into the plane and building a relief on the basis of aerial photography. To determine the normal 110 and laser point planes are grouped by location and time of shooting. Further, for each point 130 nearest neighbors are taken and are constructed planes by the RANSAC method. The normal vector of the plane that passes through the largest number of neighbors, is considered normal to a given point.

At sub-step 1032, the construction of planes for sets of cloud points 130 is performed. For the construction of planes, cloud points 130 are distributed over a planar grid. In each cell of this grid, for each point and its corresponding normal are searched for neighboring points, belonging to the plane described by this pair. Point 130 with the maximum number of neighboring points 130 along the plane, is taken as the basis for the plane, and all the neighboring points are removed from further processing, after which the process is repeated. By "neighbors along the plane" are meant the points of cloud 130 that lie in a plane containing the current point 130 and perpendicular to its normal 110. After all the planes are found, an attempt is made to combine these planes with planes from neighboring cells. Planes are combined only if the distance L between them is not greater than the specified values, for example, 30 centimeters. This principle allows us to separate buildings among themselves standing on one line.

At sub-stage 1033, the terrain is constructed using photogrammetric algorithms based on images obtained during aerial survey. Additionally, in the above-mentioned sub-step 1033, construction of reliefs of individual objects, for example, parts of buildings (roof, facade, etc.) can be done.

After the data is processed, a serial recognition of static urban objects from a set of cleaned data form laser scanning and photographic survey is performed, in which the urban objects (step 104) are defined. Objects of different types are searched in processed raw data in series, while those sets points in the clouds or areas of images that have been correlated with any object, are marked and do not participate in further processing. When the method is implemented in automated mode, detection scripts are executed in the following order: buildings and structures, fences, posts, billboards, signs and traffic lights, bus stops, other objects. The sequence can be changed manually or automatically in order to achieve the best recognition results. Also separate parts of the process can be deleted or separate, for example, you can configure script to skip a specific type of objects (poles, billboards, fences and etc.).

Each recognition script has default settings, in compliance with which the platform carries out automatic recognition. There is also the ability to create a configuration template for each search algorithm, which can then be used for default.

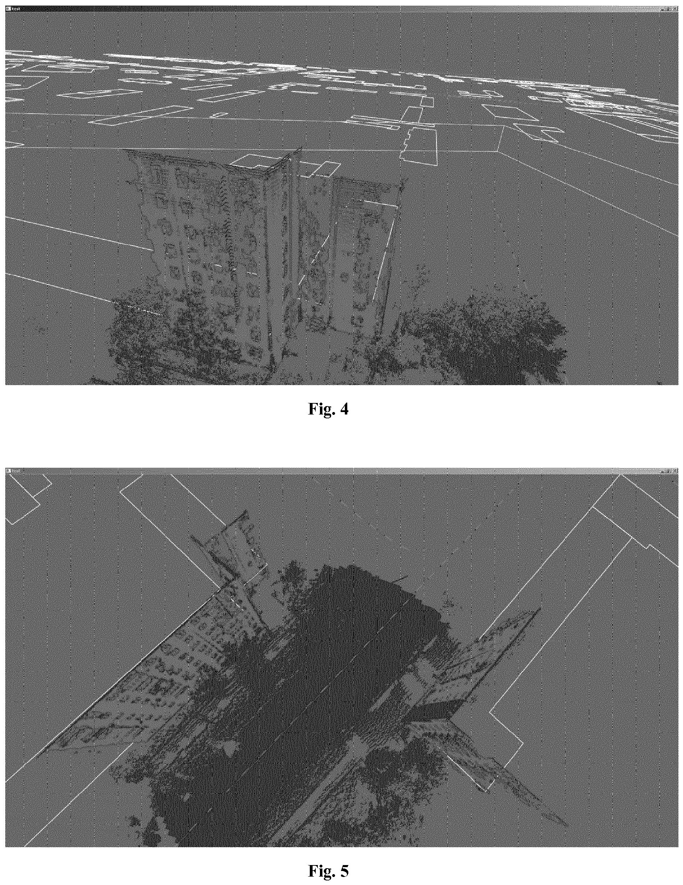

As shown in Fig. 4-5, for recognizing the building on the base of cartographic and semantic data the outline of the building and, perhaps its approximate height are defined. An array is allocated from the points cloud, which belongs to the searched object, and from the aerial survey - the necessary textures. To eliminate discrepancies in the positioning of objects on maps, in a point cloud, and panoramas an intelligent system of combination is used, which allows you to "pull" the necessary parts of the data even with a shift of several meters.

The selected information is checked for a number of key characteristics, identifying the object as a building. Such signs are: the presence of extended vertical flat surfaces along the boundaries of an object, the presence of window depressions in point clouds, the height of the object above surrounding terrain, the presence of a characteristic roof on the survey data from the air and some others.

Fencing is defined as an extended plane adjacent to land with the height of no more than a given limit. As data, preventing erroneous detection of third-party objects as a fences, a number of additional features can be used: the absence in the area of space of contours of houses, as well as other adjacent objects, no additional relief on the plane, uniform average texture color, etc.

Fig. 5 shows an example of poles recognition. In general the principle consists of three stages.
1. Isolation of cylindrical vertically oriented objects;
2. Training of adaptive boosting algorithm;
3. Classification of found objects using the constructed algorithm.

At the first stage, the points are distributed into a grid of square meters. For points of each square and its neighbors several times randomly three adjacent points are selected and a cylinder is constructed through these points. If in the grid element the centers of such cylinders lie in the same plane coordinate, this place is marked as vertically oriented cylinder. For each such place, characteristics for algorithm of training are constructed, namely:
a) radius and curvature of the surface;
b) the distribution of points along the distance from the center of the cylinder;
c) the distribution of points in the XY plane;
d) distribution of points along the vertical;
e) distance to the car track;
f) the average color of the points recorded on the three nearest panoramas;
g) the average reflection coefficient.

At the second stage, the adaptive boosting algorithm (ADABOOST) characteristics of objects and classification are provided. The algorithm builds a cascade of recognition. In our case, two separate cascades are constructed: the first is rough, screening out 95% of objects. The second is more precise, it sifts out still about 99%. This approach is used for further correction of errors - if using this algorithm a missed object is found, it is most likely to be among the objects of the first cascade. This reduces the number of viewed objects in general, without reducing the accuracy of object detection.

The recognition of traffic signs takes place in the optical range. As an auxiliary source data specially prepared database is used with a lot of real images of signs on terrain. The algorithm consists of constructing the characteristic features of the image and learning the adaptive boost cascade on examples from the existing base of signs. To eliminate errors of the second kind secondary characteristics in point clouds are monitored: linear dimensions, distance from roadway, installation height, etc.

Traffic lights are simultaneously detected in a point cloud and at photo panorama. Column of certain parameters with a characteristic of "box" of a traffic light in the point cloud are detected. In optical photography there is a search for circles with given colors. To cut off erroneous objects cartographic data about the carriageway parts and intersections are used.

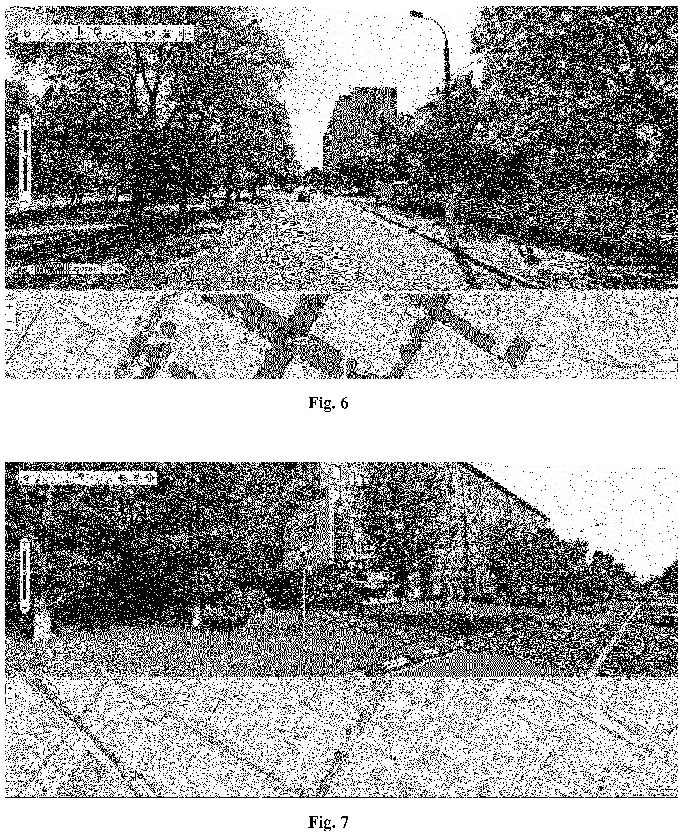

A billboard is defined as a plane located on a certain height with certain linear dimensions. To avoid Type II errors all object-applicants are checked also for the absence of other objects located near by, especially fences and buildings. Also secondary signs are checked, for example, the presence of a column as a supports, the presence of advertising textures with sharp drops of medium color (Fig. 7).

Public transport stop is detected by availability of perpendicular planes of a certain size, the horizontal plane of the characteristic texture visible from above, as well as the presence additional features: the presence of a "sign" object of a certain type and a broken yellow strip in the optical image. Also distance from the roadway and a number of other factors are monitored.

Using the claimed method 100, there is an opportunity of recognition of other objects not initially inherent in the process of recognition. For this, method 100 has the possibility of learning with a help of using real-image library analysis, and assigning several geometric parameters characterizing the dimensions and the position of objects. The training module is built on an iterative scheme and allows to learn algorithms, indicating Type I and Type II errors for each stage of recognition process.

In step 105, for each detected object, at least geographical coordinates in WGS84 (longitude, latitude and height) and linear dimensions are identified. Additionally, the following parameters can be determined:
- The area of the planes of the object (for polygonal objects);
- Object type (with subtypes for some object classes, for example road signs).

At step 106, the construction of polygonal models of found objects is carried out, containing textures in a graphic format, for example jpg, received from photographs.

The resulting spatial data can be exported to geographic files of vector formats such as SHAPEFILE, KML or GeoJSON for presentation in various GIS, into three-dimensional models in 3D formats or OBJ for use in CAD-systems, etc.

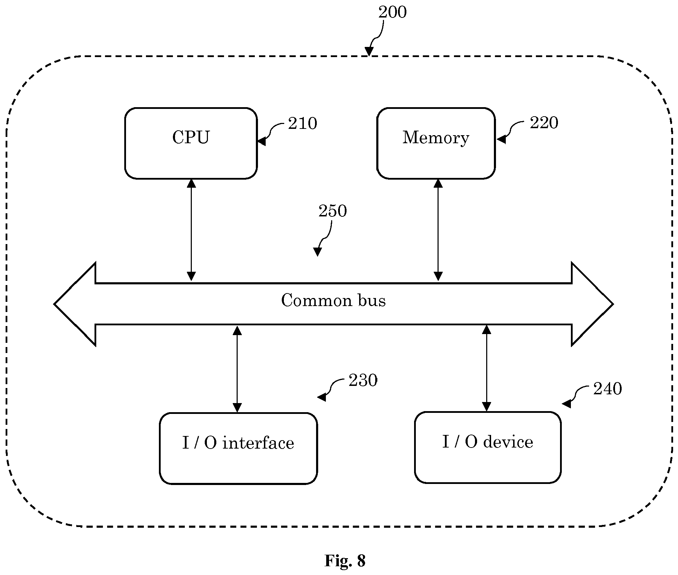

Fig. 8 represents a perspective view of a system 200 implementing steps of the above-mentioned urban object recognition method 100. System 200 is executed on the basis of a computer, for example, 1MB PC and contains, at least, such tools as: processor 210, memory 220, interfaces I / O 230 and I / O device 240 combined with a common data bus 250.

The processor 210 may be both a single computing device, and represent a combination of two or more processors. Memory 220, as a rule, includes RAM, ROM, means of data storage(HDD, SSD, optical disks, flash memory, etc.).

The I / O interfaces 230 may be, but are not limited to, for example, serial ports, parallel ports, universal
serial bus (USB), IEEE-1394 (i.Link or FireWare), LAN or any other type of interface that uses for a particular private implementation of the system 200.

I / O devices 240 may be, but are not limited to, for example, mouse, keyboard, network controller, display, touchpad, light pen, laser stylus, joystick, trackpad and so on.

The system 200 is preferably a server platform that provides the necessary calculations for implementation of the above-mentioned method 100. With particular implementation the system 200 can be implemented on the basis of mobile devices, such as a laptop, smartphone or tablet.

The information contained in the present application materials for implementation of the claimed invention should not be interpreted as an information restricting other, particular implementations, which do not go beyond the disclosure of information in the materials, and which should be obvious to those skilled in the given areas of knowledge having the usual skill, who the claimed technical solution is aimed for.

## Claims

1. A computer-implemented method for recognizing urban objects, consisting in the processing of primary data containing, at least, photographic data and laser scanning data, information on urban sites, consist of the following stages:
- cleaning and verification of the received primary data, containing city facilities;
- pre-processing of the cleared laser scanning data, in which:
- the construction of the normals to each of the cloud points is carried out;
- the construction of planes for sets of points clouds;
- the terrain is built using photogrammetric algorithms based on photographs taken from different points in space;
- a consistent recognition of static urban objects from the set of cleaned laser scanning data and photographic data, in which city objects are determined;
- for each detected urban object, at least, geographical coordinates and linear dimensions are determined;
- creation of a polygonal model for each of the detected objects.

2. The method according to claim 1, wherein the primary data comprises additionally spatial geodata and / or semantic data and / or panoramic photo images.

3. The method according to claim 2, wherein the photographic data are the data obtained by ground and / or aerial and / or space photography.

4. The method according to claim 2, wherein the spatial geodata are vector layers containing coordinates of boundaries of urban facilities.

5. The method according to claim 2, wherein the semantic data contains the metadata of urban objects.

6. The method according to claim 4, wherein in the verification step, the initial data are checked for the representative quality of information (for example, photos and point clouds are checked for blind spots from moving objects).

7. The method according to claim 1, wherein in the step of cleaning of the primary data the processing of laser scanning data is performed, in which the points are deleted from the point cloud which corresponds to the points formed due to the occurrence of interference during the laser scanning, nonstationary objects, or points that are absent on two or more laser scans of one area.

8. The method according to claim 3, wherein the testing of surface and air panoramas for a quality of image of the recognized objects.

9. The method according to claim 1, wherein in the stage of preprocessing preliminary localization of aerospace and ground photos is done, as well as the localization of point clouds for the detection of objects and determination of the order of their processing.

10. The method according to clause 1, wherein in the stage of normals construction for cloud points, for each cloud point, the nearest neighboring points are defined.

11. The method according to claim 10, wherein for each point, that has the neighboring points determined, the planes are constructed by the RANSAC method.

12. The method according to claim 11, wherein the normal to the point is the vector of normal of the plane that passes through the largest number of neighboring points.

13. The method according to claim 12, wherein when constructing planes points of the cloud are distributed on a planar grid, in each cell of which for each point and its corresponding normal the neighboring points are searched for, the points belonging to the plane described by this pair.

14. The method according to claim 13, wherein the point with the maximum number of neighboring points along the plane is taken as the basis for the plane, all of said neighboring points being removed from further processing.

15. The method according to claim 14, wherein all the detected planes in one cell are checked for compatibility with the planes of neighboring cells and if the test is successful, then the planes of neighboring points are combined.

16. The method according to claim 15, wherein the verification consists in checking the distance L between planes and if the planes are located at a distance not exceeding L, they are combined.

17. The method of claim 1, wherein in the stage of sequential recognition of static urban objects the order of searching for object types is set by the policy of the searching algorithm.

18. The method according to claim 1, wherein the definition of urban objects are carried out on the basis of characteristic features established for each type of object.

19. The method according to claim 1, wherein the definition of urban objects is carried out on the basis of comparison of identified objects from processed data with the reference objects from the database.

20. The method according to claim 1, wherein in the stage of constructing the relief terrain, the relief of individual objects is made additionally.

21. A system of recognition of urban objects, containing one or more processors and at least one memory storing machine-readable commands, which, when executed, at least, one processor performs processing of primary data containing, at least photographic data and laser scanning data, in a manner according to any one of claims 1-20.
